# FASCICULE DE BREVET EUROPEEN

(11) **EP 0 820 141 B1**
(45) Date de publication et mention de la délivrance du brevet: **07.09.2005**
(21) Numéro de dépôt: 97410039.8
(22) Date de dépôt: 25.03.1997
(51) Int. Cl.: H02M 1/08, H02M 7/162, H03K 17/13

(54) **Commande d'un pont mixte au zéro de tension**
Nullspannungsansteuerung einer hybriden Brückenschaltung
Zero voltage control for a mixed bridge

(30) Priorité: 29.03.1996 FR 9604272
(43) Date de publication de la demande: 21.01.1998
(73) Titulaire: STMicroelectronics S.A., 92120 Montrouge (FR)
(72) Inventeur: Rivet, Bertrand, 37100 Tours (FR)
(74) Mandataire: de Beaumont, Michel

(56) Documents cités:
- DE-A- 3 404 446
- GB-A- 2 002 601
- GB-A- 2 256 757
- US-A- 3 562 621
- US-A- 3 670 226

## Description

La présente invention concerne la commande d'un pont mixte de redressement au voisinage du passage au zéro de tension d'une alimentation alternative, par exemple, la tension alternative du secteur.

Un exemple d'application d'un tel pont mixte concerne le domaine des convertisseurs de puissance qui sont destinés à fournir des alimentations continues redressées, obtenues à partir d'une tension alternative, et destinées à servir de base, par exemple, à un système d'alimentation à découpage. Le pont est alors souvent associé à un circuit de limitation de l'appel de courant d'un condensateur de stockage lors de la mise sous tension d'un redresseur.

Un autre exemple d'application concerne les circuits d'alimentation d'une charge résistive, par exemple un radiateur électrique, qui doit être alimentée par une tension alternative redressée. Les normes électriques imposent généralement que la mise sous tension d'une telle charge s'effectue au voisinage du zéro de tension de l'alimentation alternative.

Les circuits classiques de commande d'un pont mixte ont généralement besoin d'être alimentés par une tension continue, basse par rapport à la tension alternative. On est donc généralement contraint de prévoir des moyens spécifiques d'alimentation du circuit de commande et, le plus souvent, un transformateur d'isolement de ces moyens par rapport à l'alimentation alternative. Cela conduit à des circuits complexes et onéreux (cf. GB-A-2 256 757).

Une autre solution selon le document DE-A-34 04 446 ne nécessite pas de transformateur mais utilise un pont redresseur supplémentaire.

En géneral, les alimentations connues utilisent un pont mixte comprenant deux thyristors à gâchette de cathode dont les cathodes sont reliées ensemble à une borne de sortie positive et dont les gâchettes sont interconnectées ainsi que deux diodes dont les anodes sont reliées ensemble à une borne négative à lequel apparaît un potentiel de référence.

Selon un premier aspect, la présente invention vise à proposer un dispositif de commande d'un pont mixte au voisinage du zéro de tension qui soit particulièrement simple et peu coûteux.

L'invention vise également à proposer un tel dispositif de commande à faible dissipation d'énergie.

Selon un deuxième aspect, la présente invention vise à proposer un circuit de limitation de l'appel de courant d'un condensateur de stockage d'un convertisseur de puissance, utilisant un tel dispositif de commande d'un pont mixte.

Le document G-B-A-2 256 757 décrit un circuit de limitation de l'appel de courant d'un condensateur de stockage d'un convertisseur de puissance dans lequel un pont mixte est commandé au voisinage du zéro de tension au moyen d'un amplificateur opérationnel. Un tel circuit nécessite un transformateur et un pont auxiliaire pour commander l'amplificateur. De plus, un condensateur de stockage additionnel est nécessaire pour alimenter cet amplificateur opérationnel.

Selon un troisième aspect, la présente invention vise à proposer un circuit pour la mise sous tension d'une charge résistive au voisinage du zéro de tension, utilisant un tel dispositif de commande d'un pont mixte.

Pour atteindre ces objets, la présente invention prévoit un dispositif de commande d'un pont mixte fournissant une alimentation redressée et comprenant deux thyristors à gâchette d'anode dont les cathodes sont reliées ensemble à une borne de sortie positive et dont les gâchettes sont interconnectées, ce dispositif comportant un interrupteur unidirectionnel, commandable en ouverture et en fermeture, connecté d'une part aux deux gâchettes et d'autre part à un potentiel de référence et un moyen de commande pour fermer l'interrupteur, uniquement dans une plage de tension prédéterminée autour du zéro de tension d'une alimentation alternative du pont mixte et, le dispositif est alimenté directement par l'alimentation alternative ou par l'alimentation redressée.

Selon un mode de réalisation de la présente invention, ledit interrupteur est monté en série avec une résistance de commande connectée au potentiel de référence.

Selon un mode de réalisation de la présente invention, le dispositif comporte une diode Zener de limitation d'une tension de commande de l'interrupteur, connectée entre une borne de commande de l'interrupteur et ledit potentiel de référence.

Selon un mode de réalisation de la présente invention, ledit interrupteur est un thyristor ouvrable par la gâchette.

Selon un mode de réalisation de la présente invention, le dispositif comporte une diode entre la gâchette de chaque thyristor du pont et l'interrupteur.

Selon un deuxième aspect, l'invention concerne également un circuit de limitation du courant d'appel d'un condensateur de stockage d'un convertisseur de puissance, comportant un dispositif de commande d'un pont mixte selon le premier aspect de l'invention.

Selon un mode de réalisation de la présente invention, ledit moyen de commande de l'interrupteur comporte :
un transistor bipolaire ayant un émetteur, un collecteur et une base, le collecteur du transistor étant relié à une borne de commande dudit interrupteur et l'émetteur du transistor étant connecté au potentiel de référence ; et
une diode Zener de commande, fixant ladite plage de tension et connectée entre une deuxième borne de sortie du pont délivrant une tension alternative redressée et la base dudit transistor.

Selon un mode de réalisation de la présente invention, le circuit de limitation du courant d'appel comporte une diode Zener de mise en service du dispositif de commande connectée, en série avec une résistance de limitation de courant, entre une borne de commande dudit interrupteur et une borne de sortie délivrant une alimentation continue redressée.

Selon un troisième aspect, l'invention concerne en outre un circuit de mise sous tension d'une charge au voisinage du passage par un zéro de tension d'une alimentation alternative redressée, comportant un dispositif de commande d'un pont mixte selon le premier aspect de l'invention.

Selon un mode de réalisation de la présente invention, ledit moyen de commande de l'interrupteur comporte :
un thyristor à gâchette de cathode commandé par un signal de mise sous tension de la charge et connecté entre une borne de commande dudit interrupteur et le potentiel de référence, ladite borne de commande de l'interrupteur étant reliée, par l'intermédiaire de résistances de limitation de courant, à deux bornes d'une alimentation alternative ; et
une diode Zener de commande connectée entre la gâchette dudit thyristor et, par l'intermédiaire de résistances de limitation de courant, aux deux bornes de l'alimentation alternative.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un mode de réalisation d'un dispositif de commande d'un pont mixte selon la présente invention ;
la figure 2 illustre, sous forme de chronogrammes, le fonctionnement d'un dispositif tel que représenté à la figure 1 ;
la figure 3 représente un mode de réalisation d'un circuit de limitation du courant d'appel d'un condensateur de stockage d'un convertisseur de puissance selon un deuxième aspect de la présente invention ;
la figure 4 illustre, sous forme de chronogrammes, le fonctionnement d'un circuit tel que représenté à la figure 3 ;
la figure 5 représente un mode de réalisation d'un circuit de commande d'une charge au voisinage du zéro de tension selon un troisième aspect de la présente invention ; et
la figure 6 illustre, sous forme de chronogrammes, le fonctionnement d'un circuit tel que représenté à la figure 5.

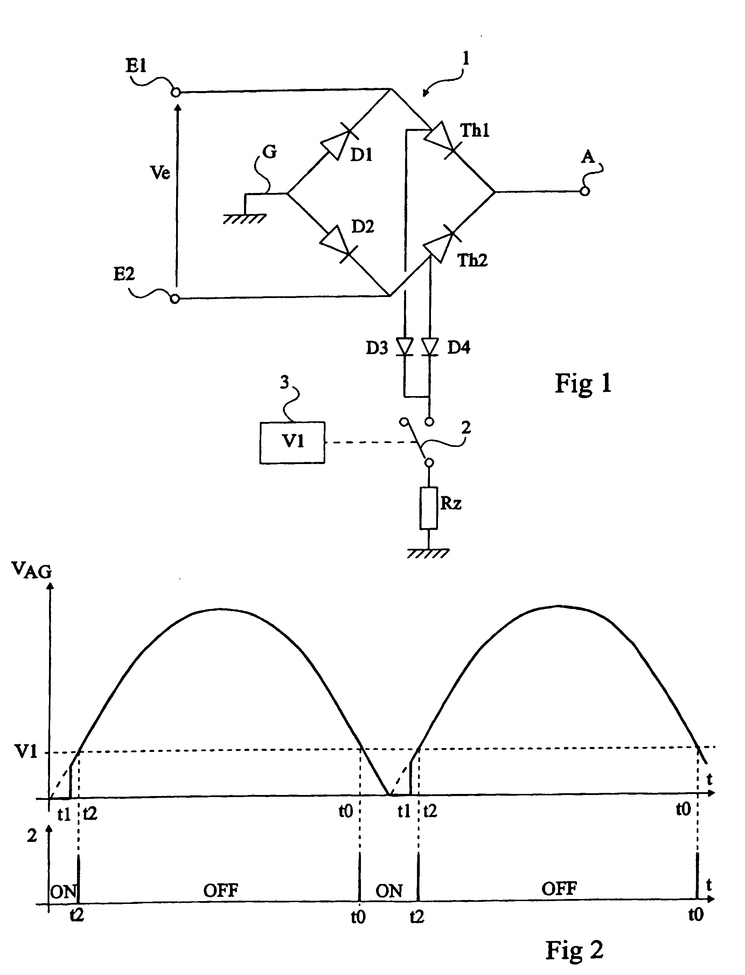

Pour des raisons de clarté, les mêmes éléments ont été désignés par les mêmes références aux différentes figures. De même, les chronogrammes des figures 2, 4 et 6 ne sont pas à l'échelle. Toujours pour des raisons de clarté, on négligera, dans la description qui suit, les chutes de tension dans des jonctions PN polarisées en direct du dispositif et des circuits décrits.

Les figures 1 et 2 illustrent le principe d'un dispositif de commande de commutateurs d'un pont mixte au voisinage du zéro de tension selon un premier aspect de la présente invention.

L'invention utilise un pont mixte 1 (figure 1) constitué de deux diodes D1 et D2 et de deux thyristors à gâchette d'anode Th1 et Th2 ou équivalent. Une première diagonale du pont 1 est connectée à des bornes E1 et E2 d'une alimentation alternative, par exemple, la tension du secteur. Une deuxième diagonale du pont 1 est connectée à des bornes A et G fournissant une alimentation redressée, la borne G fournissant un potentiel de référence, généralement la masse.

Une caractéristique de la présente invention est d'organiser la commande du pont mixte 1 au moyen d'un interrupteur 2 commandable en ouverture et en fermeture pour autoriser une mise en conduction du pont, uniquement au voisinage d'un passage par un zéro de tension de l'alimentation alternative.

L'interrupteur 2 relie les gâchettes des thyristors Th1 et Th2 à la masse (borne G) par l'intermédiaire d'une résistance de commande Rz. Deux diodes, respectivement D3 et D4, sont interposées entre les gâchettes respectives des thyristors Th1 et Th2 et l'interrupteur 2 pour éviter de court-circuiter l'alimentation alternative par les gâchettes des thyristors Th1 et Th2.

L'interrupteur 2 est associé à un moyen de commande 3 propre à l'ouvrir quand la valeur absolue de la tension alternative d'alimentation Ve excède une valeur seuil prédéterminée V1 et à le fermer quand la valeur de la tension Ve est dans une plage comprise entre -V1 et +V1. Ainsi, la mise en conduction du pont 1 n'est possible qu'à l'intérieur d'une plage de tension (-V1, +V1) choisie pour être au voisinage du zéro de tension. Une fois déclenchés, les thyristors du pont restent cependant conducteurs jusqu'à la fin de l'alternance pour fournir l'alimentation redressée souhaitée.

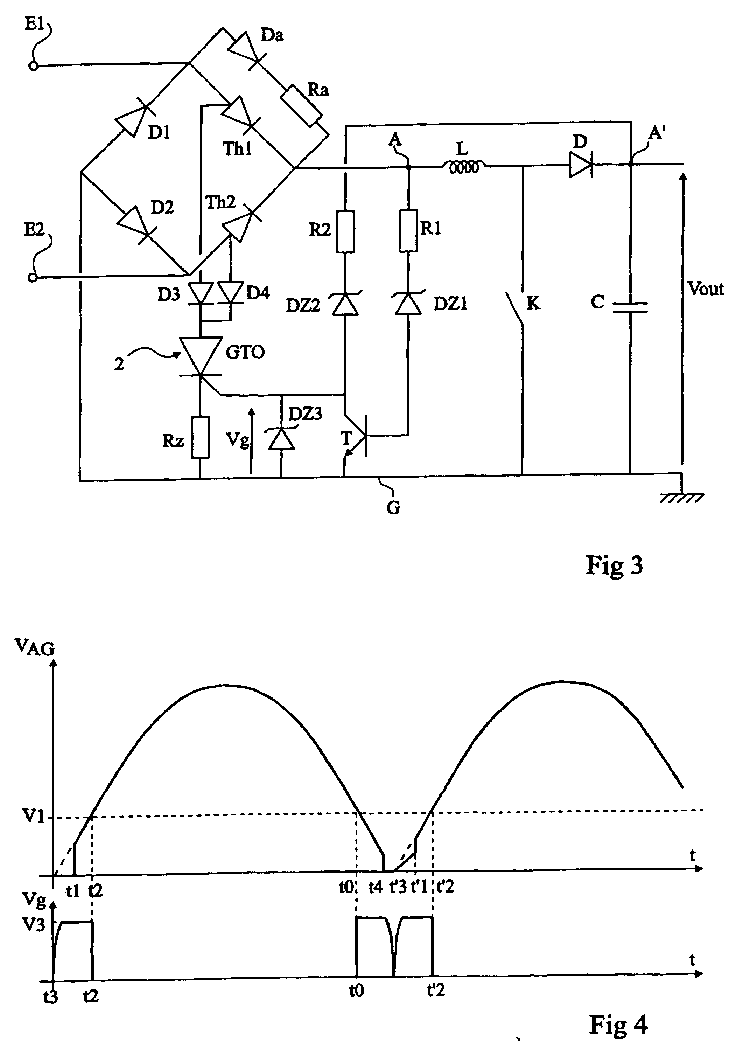

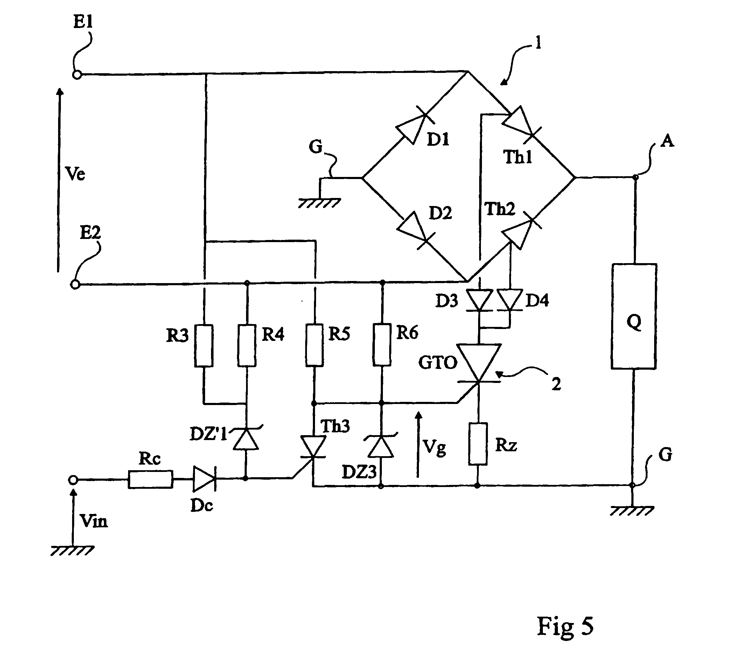

Une caractéristique de la présente invention est que le moyen de commande 3 est alimenté directement par l'alimentation alternative ou par l'alimentation redressée fournie par le pont mixte. Cette caractéristique ressortira mieux de la description des figures 3 et 5.

Selon un mode de réalisation préféré de l'invention, l'interrupteur 2 est un thyristor commandable à l'ouverture par la gâchette (GTO). On notera cependant qu'il peut être remplacé par un transistor MOS ou bipolaire de puissance. On notera également que l'interrupteur 2 est, soit unidirectionnel par nature (cas du thyristor GTO), soit rendu unidirectionnel au moyen des diodes D3 et D4 intercalées entre l'interrupteur 2 et les gâchettes des thyristors Th1 et Th2.

La figure 2 illustre le fonctionnement d'un circuit de commande tel que représenté à la figure 1. La figure 2 représente, sous forme de chronogrammes, l'allure de la tension de sortie V_{AG} du pont 1 et les périodes d'ouverture (désignées "OFF") et de fermeture (désignées "ON") de l'interrupteur 2.

A chaque fin d'alternance de la tension Ve (non représentée à la figure 2), l'interrupteur 2 est fermé dès que la valeur absolue de la tension Ve (ou la valeur de la tension V_{AG} en négligeant les chutes de tension dans les jonctions PN de la diode et du thyristor du pont qui conduisent) devient inférieure à la tension seuil V1 (instant t0). Il reste fermé tant que la tension Ve n'a pas atteint la tension V1 au début de l'alternance suivante, pour autoriser la mise en conduction du thyristor Th1 ou Th2 polarisé en direct lors de l'alternance suivante.

Selon l'invention, la résistance Rz et la tension seuil V1 (par exemple de l'ordre de 10 à 20 volts) sont choisies pour que le courant qui traverse l'interrupteur 2, lorsqu'il est fermé, atteigne le courant d'amorçage d'un des thyristors du pont 1 (en tenant compte de la résistance série de l'interrupteur 2). Dès que ce courant est suffisant (instant t1), le thyristor polarisé en direct s'amorce et le pont est mis en conduction jusqu'à la fin de l'alternance.

L'ouverture de l'interrupteur 2 (instant t2), lorsque la tension V_{AG} atteint le seuil V1 au voisinage du début de l'alternance, permet, outre d'interdire tout nouveau démarrage du pont au sein de la même alternance, par exemple en cas de micro-coupure de la tension Ve, de diminuer considérablement la dissipation d'énergie dans la résistance Rz.

Un avantage de la présente invention est que la dissipation d'énergie dans la résistance Rz s'effectue uniquement sous faible tension et pendant une courte période, à chaque alternance.

L'invention sera décrite par la suite dans deux exemples d'application qui en illustrent deux autres aspects.

Les figures 3 et 4 se rapportent à un deuxième aspect de la présente invention pour une application à un circuit de limitation du courant d'appel d'un condensateur de stockage d'un convertisseur de puissance destiné, par exemple, à un système d'alimentation à découpage.

Une inductance L, en série avec une diode D, est intercalée entre la borne A du pont 1 et une première borne A' d'un condensateur de stockage C dont l'autre borne est connectée à la masse (borne G). Un interrupteur K est connecté entre l'anode de la diode D et la masse pour générer une tension continue en prélevant, sur le secteur, un courant qui soit en phase avec la tension alternative. La tension Vout entre les bornes A' et G constitue une tension d'alimentation continue régulée, par exemple, de 400 volts. Dans l'exemple représenté, le convertisseur est donc associé à un circuit, dit de compensation du facteur de puissance. On notera cependant que ce circuit de compensation peut être réalisé par d'autres moyens classiques, voire être omis selon l'application.

La limitation du courant d'appel du condensateur C est effectuée au moyen d'une résistance Ra, en série avec une diode Da, montées en parallèle sur un des thyristors, par exemple Th1, du pont. Selon les applications, un seul thyristor est associé à une résistance Ra et à une diode Da ou les deux thyristors sont associés à une résistance Ra et à une diode Da.

Selon l'invention, un dispositif de commande tel que représenté à la figure 1 est associé au pont mixte. Le moyen de commande de l'interrupteur 2, ici un thyristor GTO, comporte un transistor bipolaire T dont le collecteur est relié à la gâchette du thyristor GTO et dont l'émetteur est relié à la masse. La base du transistor T est reliée, par l'intermédiaire d'une diode Zener DZ1 de commande, en série avec une résistance R1 de limitation du courant de base, à la borne A de sortie du pont 1. La tension seuil V1 de la diode DZ1 fixe la plage de fermeture du thyristor GTO.

La gâchette du thyristor GTO est également reliée, par l'intermédiaire d'une diode Zener DZ2, en série avec une résistance R2 de limitation de courant, à la borne A' du condensateur C. Le rôle de la diode DZ2 est d'interdire le fonctionnement du dispositif de commande tant que le circuit de correction du facteur de puissance n'est pas en régime établi, c'est-à-dire de forcer la circulation du courant à travers la diode Da et la résistance Ra pour permettre la charge initiale du condensateur C. La tension seuil V2 de la diode DZ2 est élevée (de l'ordre de plusieurs centaines de volts). La diode DZ2 constitue donc un moyen de mise en service du dispositif de commande.

Initialement, lorsque le condensateur C est déchargé, la tension Vout est nulle et le thyristor GTO est bloqué (il ne reçoit aucun courant de gâchette). Les thyristors Th1 et Th2 sont donc également bloqués. La charge initiale du condensateur C s'effectue donc par un courant traversant la diode Da et la résistance Ra.

Dès que la charge du condensateur C atteint la valeur V2, la diode DZ2 entre en avalanche, ce qui rend le thyristor GTO conducteur.

De préférence, une diode Zener DZ3 de protection est placée entre la gâchette du thyristor GTO et la masse. La diode DZ3 permet, à la fois, de limiter la tension de gâchette du thyristor GTO et de protéger le transistor T, ce qui permet d'utiliser un transistor basse-tension. On notera que la résistance R2 permet d'éviter tout conflit qui interviendrait autrement entre le niveau de charge du condensateur C et les seuils des diodes Zener DZ2 et DZ3 qui seraient, en l'absence de résistance R2, connectées en série entre la borne A' et la masse.

Le dispositif de commande selon l'invention est alors en service tant que le régime établi se maintient, c'est-à-dire tant que la diode DZ2 est en avalanche.

Le fonctionnement du circuit selon l'invention en régime établi sera expliqué en relation avec la figure 4 qui représente, sous forme de chronogrammes, la tension V_{AG} et la tension de gâchette Vg du thyristor GTO.

Au début d'une alternance du régime établi (instant t3), les thyristors Th1 et Th2 sont bloqués. Le transistor T est également bloqué dans la mesure où la diode DZ1 ne conduit pas (la tension V_{AG} est nulle). Le thyristor GTO peut conduire dans la mesure où la diode DZ2 est en avalanche. La tension Vg est limitée à la tension seuil V3 de la diode DZ3.

A un instant t1, où le courant dans le thyristor GTO et la résistance Rz est suffisant pour amorcer un des thyristor Th1 ou Th2, celui des thyristors (Th2, dans l'exemple représenté) qui est polarisé en direct devient conducteur. La tension V_{AG} rejoint alors la forme de l'alternance redressée.

A un instant t2, où la tension V_{AG} atteint la tension seuil V1 de la diode DZ1, celle-ci entre en avalanche et le transistor T sature. Le thyristor GTO se bloque, ce qui supprime toute dissipation d'énergie dans la résistance Rz. Le thyristor Th2 reste cependant conducteur tant qu'il est polarisé en direct, c'est-à-dire sensiblement jusqu'à la fin de l'alternance (instant t3).

A un instant t0, voisin de la fin de l'alternance, où la tension V_{AG} devient inférieure au seuil V1, le transistor T se bloque, ce qui rend le thyristor GTO de nouveau conducteur.

En pratique, le thyristor Th2 se bloque à un instant t4, postérieur à l'instant t0, où le courant qui le traverse devient inférieur à son courant de maintien.

Le fonctionnement décrit ci-dessus se reproduit pour l'alternance suivante (instants t'1 et t'2) avec le thyristor Th1. La seule distinction réside dans le fait qu'entre les instants t'1 et t'2, la tension V_{AG} n'est pas nulle. En effet, un courant circule dans la résistance Ra tant que le thyristor Th1 n'est pas conducteur. Cette distinction disparaît si le thyristor Th2 est également associé à une résistance Ra et à une diode Da.

Le convertisseur de puissance doit fonctionner au voisinage du zéro de tension pour un fonctionnement correct du circuit de correction du facteur de puissance. Cela implique que les thyristors Th1 et Th2 doivent s'amorcer dès que la tension d'alimentation a atteint un niveau suffisant (par exemple, de l'ordre de 10 à 20 volts). Ainsi, la résistance Rz est choisie suffisamment faible pour que le courant qui traverse le transistor GTO atteigne rapidement le courant de gâchette Igt nécessaire à l'amorçage d'un des thyristors Th1 ou Th2. On tiendra également compte du fait que ce courant Igt doit pouvoir circuler dans la résistance Rz avant que la tension d'alimentation atteigne la tension V1.

A titre de variante de réalisation, la diode DZ1 pourra être remplacée par un pont diviseur résistif dont le point milieu est relié à la base du transistor T.

On notera que les pertes résistives dans la ou les résistances Ra sont minimisées en régime établi dans la mesure où elles interviennent sous une faible tension (inférieure à V1).

On notera également que le dispositif de commande est directement alimenté par l'alimentation alternative redressée et ne nécessite ni transformateur, ni pont redresseur supplémentaire, ni condensateur de stockage additionnel.

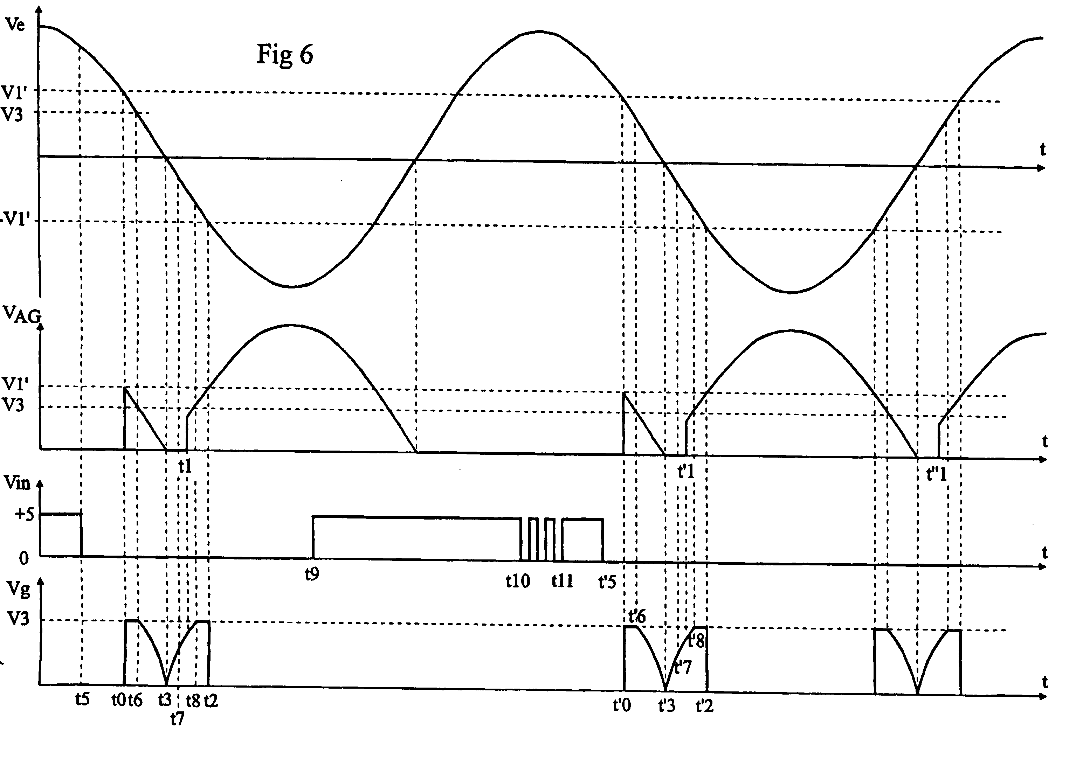

Les figures 5 et 6 se rapportent à un troisième aspect de la présente invention pour une application à un circuit de commande d'une charge résistive, par exemple un radiateur électrique.

Ici, le dispositif de commande tel que représenté à la figure 1 sert à valider un signal Vin de mise sous tension d'une charge Q, alimentée par une tension alternative redressée V_{AG}, pour s'assurer que cette mise sous tension s'effectue au voisinage d'un zéro de tension.

Un signal de commande logique Vin (par exemple, 0 et 5 volts) est appliqué, de préférence par l'intermédiaire d'une résistance Rc et d'une diode Dc, à la gâchette d'un thyristor Th3. La cathode du thyristor Th3 est connectée à la masse (borne G) et son anode est reliée à la borne de commande de l'interrupteur 2, ici la gâchette d'un thyristor GTO.

La commande du thyristor GTO est effectuée sur la base de la tension alternative d'alimentation Ve. Le seuil de tension Vl', fixant la plage de fermeture du thyristor GTO, est fixé par une diode Zener de commande DZl' reliée à la gâchette du thyristor Th3 et, par l'intermédiaire de résistances, respectivement R3 et R4, à chacune des bornes E1 et E2 de l'alimentation alternative Ve.

La gâchette du thyristor GTO est également reliée, par l'intermédiaire de résistances, respectivement R5 et R6, à chacune des bornes E1 et E2 de l'alimentation alternative.

De préférence, une diode Zener DZ3 est connectée entre la gâchette du thyristor GTO et la masse. Le rôle de cette diode DZ3 est de limiter la tension de gâchette du thyristor GTO. On veillera à ce que la tension seuil V3 de la diode DZ3 soit inférieure au seuil V1'.

Les résistances R3 et R4 qui limitent le courant de gâchette du thyristor Th3 sont de même valeur et sont dimensionnées en fonction de la tension seuil de la diode DZ1', en tenant compte du courant Igt nécessaire à l'amorçage du thyristor Th3. De la même manière, les résistances R5 et R6 sont de même valeur et sont dimensionnées en fonction de la tension seuil de la diode DZ3 en tenant compte du courant Igt nécessaire à l'amorçage du thyristor GTO.

On notera que le dispositif de commande est ici directement alimenté par l'alimentation alternative. Le signal Vin est produit séparément mais la validation de la mise sous tension de la charge Q au moyen du dispositif selon l'invention ne nécessite pas de moyens d'alimentation isolés de l'alimentation alternative.

Ainsi, comme pour le circuit exposé en relation avec la figure 3, la mise en oeuvre de l'invention ne nécessite ni transformateur, ni pont supplémentaire, ni condensateur additionnel pour alimenter le dispositif de commande selon l'invention qui est particulièrement simple et peu coûteux.

Le fonctionnement du circuit tel que représenté à la figure 5 sera décrit par la suite en relation avec la figure 6 qui représente, sous forme de chronogrammes, l'allure de la tension de sortie V_{AG} du pont 1 et de la tension Vg de gâchette du thyristor GTO, en fonction d'un signal d'alimentation alternative Ve et d'un signal de mise sous tension Vin.

On suppose qu'un état bas (par exemple, 0 volt) du signal Vin indique une commande de mise sous tension de la charge Q tandis qu'un état haut (par exemple, 5 volts) indique que la charge Q ne doit pas être alimentée.

On suppose qu'une commande de mise sous tension intervient pendant une alternance positive à un instant t5 où la tension Ve est supérieure à la tension seuil V1' de la diode DZ1'. Comme la diode DZ1' est en avalanche, le thyristor Th3 conduit. Cela interdit toute mise en conduction du pont 1 dans la mesure où la gâchette du thyristor GTO est alors forcée à la masse.

Lorsque vers la fin de l'alternance, la tension Ve devient inférieure à la tension V1' (instant t0), le thyristor Th3 va se bloquer dès que le courant qui le traverse devient inférieur à son courant de maintien dans la mesure où le signal Vin est toujours à l'état bas. Pour des raisons de clarté, le blocage du thyristor Th3 est cependant indiqué à l'instant t0 en figure 6. Le thyristor GTO s'amorce immédiatement et sa tension de gâchette est limitée à la tension V3. Un des thyristors (par exemple Th1) du pont 1 entre en conduction à l'instant t0 et reste conducteur sensiblement jusqu'à la fin de l'alternance (instant t3).

A un instant t6 (compris entre les instants t0 et t3) où la tension Ve devient inférieure à V3, la tension Vg se met à décroître jusqu'à zéro et le thyristor GTO se bloque.

Au début de l'alternance suivante, le thyristor Th3 est toujours bloqué (le signal Vin est à l'état bas). La tension Vg croît en suivant l'allure de la tension alternative.

A un instant t7, où un courant suffisant circule dans une des résistances R5 ou R6, le thyristor GTO s'amorce.

A un instant t1, où le courant traversant le thyristor GTO et la résistance Rz atteint le courant d'amorçage Igt d'un des thyristors du pont (par exemple, Th2), celui-ci s'amorce et le pont est mis en conduction.

A un instant t8, la tension Vg est limitée à la tension V3 jusqu'à un instant t2 où la tension Ve devient (en valeur absolue) supérieure au seuil V1' et où le thyristor GTO se bloque par suite de l'amorçage du thyristor Th3.

On notera qu'entre les instants t8 et t2, le courant qui circule dans le thyristor GTO est constant. Les résistances R3 à R6 et Rz, et les tensions V1' et V3 doivent donc être choisies pour que l'instant t8 soit postérieur à l'instant t1 d'amorçage d'un des thyristor Th1 ou Th2 du pont 1.

Si à un instant t9, le signal Vin passe à l'état haut indiquant une commande d'extinction de l'alimentation de la charge, cette commande est prise en compte à l'alternance suivante dans la mesure où le thyristor du pont qui conduit se bloque seulement lorsque la tension à ses bornes devient nulle.

Par contre, si suite à des instants t'5, t'0, t'6, t'3, t'7, t'1, t'8 et t'2 reproduisant le fonctionnement des instants t5, t0, t6, t3, t7, t1, t8 et t2, le signal Vin est toujours à l'état bas à la fin de l'alternance, le thyristor associé aux alternances de signe opposé entre en conduction à un instant t"1 et le fonctionnement des instants t0 à t2 se reproduit à chaque alternance.

Ainsi, la mise sous tension de la charge Q intervient uniquement dans une plage de tension prédéterminée (-V1', +V1') autour du zéro de tension de l'alimentation alternative.

On notera que le fonctionnement de la charge Q n'est pas altéré par des micro-coupures du signal Vin (instants t10 à t11) dans la mesure où, à la fois, la mise en conduction et l'extinction du pont 1 se produisent uniquement au voisinage du passage par zéro de l'alimentation alternative. Pour les mêmes raisons, le circuit est insensible à d'éventuels rebonds du signal Vin (oscillations du signal Vin lors d'un changement d'état).

Bien entendu, la présente invention est susceptible de diverses variantes et modifications qui apparaîtront à l'homme de l'art. En particulier, le choix des valeurs des résistances et des tensions seuils des diodes Zener dépend de la plage de fonctionnement souhaitée pour l'interrupteur et des courants nécessaires à l'amorçage des thyristors de pont mixte. De plus, le dispositif de commande d'un pont mixte selon l'invention s'applique à d'autres circuits convertisseurs de puissance que ceux décrits en relation avec les figures 3 et 5. En outre, au lieu de thyristors à gâchette d'anode, on pourra utiliser des composants équivalents, par exemple, des triacs dont les gâchettes sont en série avec les diodes D3 et D4.

## Revendications

1. Dispositif de commande d'un pont mixte fournissant une alimentation redressée et comprenant deux thyristors à gâchette d'anode (Th1, Th2) dont les cathodes sont reliées ensemble à une borne (A) de sortie positive et dont les gâchettes sont interconnectées, **caractérisé en ce que** ce dispositif comporte :
un interrupteur unidirectionnel (2), commandable en ouverture et en fermeture, connecté d'une part aux deux gâchettes par des diodes respectives (D3, D4) et d'autre part à un potentiel de référence (G) ; et
un moyen de commande (3) pour fermer l'interrupteur (2), uniquement dans une plage de tension prédéterminée (-V1, +V1; -V1', +V1') autour du zéro de tension d'une alimentation alternative (Ve) du pont mixte (1) ; et
**en ce que** le dispositif est alimenté directement par l'alimentation alternative ou par l'alimentation redressée ne nécessitant ni transformateur, ni pont redresseur supplémentaire, ni condensateur de stockage additionnel.

2. Dispositif de commande d'un pont mixte selon la revendication 1, **caractérisé en ce que** ledit interrupteur (2) est un thyristor ouvrable par la gâchette (GTO).

3. Circuit de limitation du courant d'appel d'un condensateur de stockage (C) d'un convertisseur de puissance, **caractérisé en ce qu'**il comporte un dispositif de commande d'un pont mixte (1) selon l'une quelconque des revendications 1 ou 2.

4. Circuit selon la revendication 3, **caractérisé en ce que** ledit moyen de commande de l'interrupteur (GTO) comporte :
un transistor bipolaire (T) ayant un émetteur, un col-lecteur et une base, le collecteur du transistor (T) étant relié à une borne de commande dudit interrupteur (GTO) et l'émetteur du transistor (T) étant connecté au potentiel de référence (G) ; et
une diode Zener (DZ1) de commande, fixant ladite plage de tension (-V1, +V1) et connectée entre une deuxième borne (A) de sortie du pont (1) délivrant une tension alternative redressée (V_{AG}) et la base dudit transistor (T).

5. Circuit selon la revendication 3 ou 4, **caractérisé en ce qu'**il comporte une diode Zener (DZ2) de mise en service du dispositif de commande connectée, en série avec une résistance de limitation de courant (R2), entre une borne de commande dudit interrupteur (GTO) et une borne (A') de sortie délivrant une alimentation continue redressée (Vout).

6. Circuit de mise sous tension d'une charge (Q) au voisinage du passage par un zéro de tension d'une alimentation alternative redressée (V_{AG}), **caractérisé en ce qu'**il comporte un dispositif de commande d'un pont mixte (1) selon l'une quelconque des revendications 1 ou 2.

7. Circuit selon la revendication 6, **caractérisé en ce que** ledit moyen de commande de l'interrupteur (GTO) comporte :
un thyristor à gâchette de cathode (Th3) commandé par un signal (Vin) de mise sous tension de la charge (Q) et connecté entre une borne de commande dudit interrupteur (GTO) et le potentiel de référence (G), ladite borne de commande de l'interrupteur (GTO) étant reliée, par l'intermédiaire de résistances (R5, R6) de limitation de courant, à deux bornes (E1, E2) d'une alimentation alternative (Ve) ; et
une diode Zener (DZ1') de commande connectée entre la gâchette dudit thyristor (Th3) et, par l'intermédiaire de résistances (R3, R4) de limitation de courant, aux deux bornes (E1, E2) de l'alimentation alternative (Ve).

## Patentansprüche

1. Eine Vorrichtung zur Steuerung einer Brückenschaltung, die eine Wechselspannung empfängt und eine gleichgerichtete Versorgung liefert und
wobei zwei Anoden-Gate-Thyristoren (Th1, Th2) vorgesehen sind, deren Kathoden miteinander mit einer positiven Ausgangsklemme (A) verbunden sind und wobei die Gates miteinander in Verbindung stehen,
**dadurch gekennzeichnet, dass** die Vorrichtung Folgendes aufweist:
einen steuerbaren und ein- und ausschaltbaren Ein-Ausschalter (2) der einerseits mit den zwei Gates über entsprechende Dioden (D3, D4) und der andererseits mit einem Bezugspotential (G) verbunden ist; und
Steuermittel (3) zum Einschalten des Schalters (2) nur in einem vorbestimmten Spannungsbereich (-V1, +V1; -V1', +V1') um eine Nullspannung einer Wechselstromleistungsversorgung (Ve) der Brückenschaltung (1) herum; und
wobei die Vorrichtung direkt mit der Wechselspannung oder der gleichgerichteten Spannung versorgt wird, was keinen Transformator, keine zusätzliche Gleichrichtungsbrücke und auch keinen zusätzlichen Speicherkondensator erforderlich macht.

2. Vorrichtung zur Steuerung einer Brückenschaltung nach Anspruch 1, **dadurch gekennzeichnet, dass** der Schalter (2) ein Gate-Abschaltthyristor (GTO = gate turn-off thyristor) ist.

3. Eine Schaltung zur Begrenzung eines Stromanstiegs in einem Speicherkondensator (C) eines Leistungsumwandlers, **dadurch gekennzeichnet, dass** er eine Vorrichtung zur Steuerung einer Brückenschaltung (1) gemäß Anspruch 1 oder 2 aufweist.

4. Schaltung nach Anspruch 3 **dadurch gekennzeichnet, dass** die Mittel zur Steuerung des Schalters (GTO) Folgendes aufweisen:
ein Bipolartransistor (T) mit einem Emitter, einem Kollektor und einer Basis, wobei der Kollektor des Transistors (T) mit dem Steueranschluss des Schalters (GTO) und der Emitter des Transistors (T) mit dem Bezugspotential (G) verbunden sind; und eine Steuer-Zenerdiode (DZ1), die den Spannungsbereich (-V1, +V1) einstellt und zwischen einem zweiten eine gleichgerichtete Wechselspannung (V_{AG}) am Ausgang der Brücke (1) liefernden Ausgangsanschluss (A) und der Basis des Transistors (T), liegt.

5. Schaltung nach Anspruch 3 oder 4 mit einer Zenerdiode (DZ2) um die Steuervorrichtung in Betrieb zu bringen und zwar geschaltet in Serie mit einem Strombegrenzungswiderstand (R2) zwischen einem Steueranschluss des Schalters (GTO) und einem Ausgangsanschluss (A') der eine gleichgerichtete Gleichspannungsversorgung (Vₒᵤₜ) abgibt.

6. Eine Schaltung zur Leistungsversorgung einer Last (Q) in der Nähe eines Nulldurchgangs einer gleichgerichteten Wechselspannung (V_{AG}) **dadurch gekennzeichnet, dass** die Schaltung eine Vorrichtung zur Steuerung einer Brückenschaltung (1) gemäß Anspruch 1 oder 2 aufweist.

7. Eine Schaltung nach Anspruch 6 **dadurch gekennzeichnet, dass** die Mittel zur Steuerung des Schalters (GTO) Folgendes aufweisen:
einen durch ein Signal (Vin) gesteuerten Anoden-Gatethyristor (Th3) zur Leistungsversorgung der Last (Q) und zwar geschaltet zwischen einem Steueranschluss des Schalters (GTO) und dem Bezugspotential (G), wobei der Anschluss zur Steuerung des Schalters (GTO) über Strombegrenzungswiderstände (R5, R6) mit zwei Anschlüssen (E1, E2) einer Wechselstromversorgung (Ve) verbunden ist; und eine Zenerdiode (DZ1') die mit dem Gate des Thyristors (Th3) und über Strombegrenzungswiderstände (R3, R4) mit zwei Anschlüssen (E1, E2) der Wechselstromversorgung (Ve) verbunden ist.

## Claims

1. A device for controlling a composite bridge, receiving an a.c. voltage and providing a rectified supply, and including two anode-gate thyristors (Th1, Th2), the cathodes of which are connected together to a positive output terminal (A), and the gates of which are interconnected, **characterized in that** said device includes:
a single-throw switch (2), controllable to be turned off and on, connected on the one hand to the two gates through respective diodes (D3, D4) and on the other hand to a reference potential (G); and
control means (3) to turn on the switch (2), only in a predetermined voltage range (-V1, +V1; -V1', +V1') around zero voltage of an a.c. power supply (Ve) of the composite bridge (1); and
said device is directly supplied by said a.c. voltage or said rectified voltage, not necessitating a transformer and additional rectifying bridge, nor an additional storing capacitor.

2. A device for controlling a composite bridge according to claim 1, **characterized in that** said switch (2) is a gate turn-off thyristor (GTO).

3. A circuit for limiting a current surge in a storage capacitor (C) of a power converter, **characterized in that** it includes a device for controlling a composite bridge (1) according to claim 1 or 2.

4. A circuit according to claim 3, **characterized in that** the means for controlling the switch (GTO) include:
a bipolar transistor (T) having a transmitter, a collector and a base, the collector of the transistor (T) being connected to a control terminal of the switch (GTO) and the transmitter of the transistor (T) being connected to the reference potential (G); and
a control Zener diode (DZ1), setting the voltage range (-V1, +V1) and connected between a second output terminal (A) of the bridge (1) issuing a rectified a.c. voltage (V_{AG}) and the base of the transistor (T).

5. A circuit according to claim 3 or 4, including a Zener diode (DZ2) for bringing the control device into service connected, in series with a current limiting resistor (R2), between a control terminal of the switch (GTO) and an output terminal (A') issuing a d.c. rectified power supply (Vout).

6. A circuit for powering-on a load (Q) in the vicinity of a zero crossing of a rectified a.c. voltage (V_{AG}), **characterized in that** it includes a device for controlling a composite bridge (1) according to claim 1 or 2.

7. A circuit according to claim 6, **characterized in that** the means for controlling the switch (GTO) include:
an anode-gate thyristor (Th3) controlled by a signal (Vin) for powering-on the load (Q) and connected between a control terminal of the switch (GTO) and the reference potential (G), said terminal for controlling the switch (GTO) being connected, via current limiting resistors (R5, R6), to two terminals (E1, E2) of an a.c. supply (Ve); and
a Zener diode (DZ1') connected between the gate of the thyristor (Th3) and, via current limiting resistors (R3, R4), to the two terminals (E1, E2) of the a.c. supply (Ve).
